(19) Europäisches Patentamt
European Patent Office
Office européen des brevets

(11) **EP 4 600 202 A1**

(12) **EUROPEAN PATENT APPLICATION**

(43) Date of publication:
**13.08.2025 Bulletin 2025/33**

(21) Application number: **25155507.4**

(22) Date of filing: **03.02.2025**

(51) International Patent Classification (IPC):
**B81B 3/00** $^{(2006.01)}$

(52) Cooperative Patent Classification (CPC):
**B81B 3/0062;** B81B 2201/047; B81B 2203/0136;
B81B 2203/0154; B81B 2203/0181

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **12.02.2024 IT 202400002950**

(71) Applicant: **STMicroelectronics International N.V.**
**1228 Plan-les-Ouates, Geneva (CH)**

(72) Inventors:
• **CARMINATI, Roberto**
  **25052 Piancogno (BS) (IT)**
• **RIANI, Manuel**
  **22100 Como (IT)**
• **GATTERE, Gabriele**
  **21040 Castronno (VA) (IT)**
• **FERRARI, Giacomo**
  **27043 Broni (PV) (IT)**

(74) Representative: **Studio Torta S.p.A.**
**Via Viotti, 9**
**10121 Torino (IT)**

(54) **MICROELECTROMECHANICAL DEVICE FOR IMAGE SENSOR STABILISATION PURPOSES**

(57) A microelectromechanical device (1) includes: a substrate (1a); a platform (2), suspended and movable with respect to the substrate (1a); and actuators (3), arranged on the substrate (1a) around the platform (2), coupled to respective coupling portions (6) of the platform (2) and having respective actuation axes (X, Y) parallel to the substrate (1a) and perpendicular to each other. The device (1) further includes connection structures (4), each connection structure (4) coupling a respective actuator (3) with the platform (2) and comprising a respective motion conversion elastic element (5) interposed between the respective actuator (3) and the platform (2). Each motion conversion elastic element (5) is configured to convert movements of the actuators (3) along the respective actuation axes (X, Y) into movements of the respective coupling portions (6) of the platform (2) along directions transverse to the substrate (1a).

FIG. 5

EP 4 600 202 A1

## Description

Technical Field

The present invention relates to a microelectromechanical device for image sensor stabilization purposes.

Background

As is known, the stabilization of images generated by camera sensors, for example smartphone cameras, is an important operation in motion blur compensation systems, caused, for example, by the simple movement of the subject with respect to the camera, by out-of-focus conditions and physical limitations of the same camera's optics such as diffraction and lens aberrations.

Optical Image Stabilization (OIS) and Sensor Shift Stabilization (SSS) are the two techniques currently used to maintain an image in focus at the same position on the sensor (known as "image sensor"): the first exploits movements of the lens barrel, while the second exploits the movements of the image sensor with respect to the camera lens barrel.

The sensor shift stabilization technique is the most widespread in the electronics of smart devices and generally takes into account at least two degrees of freedom (for example, an in-plane translation) for the movement of the support having the image sensor mounted thereon. Furthermore, a focus function may be implemented by introducing out-of-plane translations.

The commercially available, and/or known, solutions for stabilizers that implement sensor shift stabilization functions may comprise voice-coil-type actuators and flexures for moving the image sensor, or alternatively microelectromechanical (MEMS) actuators based, for example, on vertical comb electrodes. However, current solutions may have issues related to energy consumption and/or may be limited in the range of movement of the image sensor as they involve actuators that operate mainly out of plane.

Summary

It is therefore an aim of the present invention to overcome or at least partially mitigate the disadvantages and limitations of the state of the art.

According to the present invention, a microelectromechanical device is presented as defined in the attached claims.

Brief Description of the Drawings

For a better understanding of the present invention, preferred embodiments are presented, by way of non-limiting example, with reference to the attached drawings, wherein:

- Figure 1 schematically shows, in a top-plan view, a MEMS device in accordance with an embodiment of the present invention;

- Figure 2 schematically shows an enlarged portion of the MEMS device of Figure 1;

- Figure 3 schematically shows, in a cross-section, an enlarged portion of the MEMS device of Figure 1;

- Figure 4 schematically shows the enlarged portion of Figure 2 with elements removed;

- Figure 5 schematically shows, in a perspective view, a portion of an element of the MEMS device of Figure 1;

- Figures 6a-6c and 7a-7c schematically show, in respective cross-sections, the operating principle of the element of Figure 5;

- Figure 8a schematically shows the portion of Figure 4 in an operating condition of the MEMS device of Figure 1;

- Figures 8b and 8c schematically show, in a same cross-section, two distinct enlarged portions of the MEMS device of Figure 1 in the operating condition of Figure 8a;

- Figure 8d schematically shows, in the same cross-section as Figures 8b and 8c, the arrangement of an element of the MEMS device of Figure 1 in the operating condition of Figure 8a;

- Figures 9a and 9b schematically show, in a same cross-section, two distinct enlarged portions of the MEMS device of Figure 1 in a different operating condition;

- Figure 9c schematically shows, in the same cross-section as Figures 9a and 9b, the arrangement of an element of the MEMS device of Figure 1 in the operating condition of Figures 9a and 9b; and

- Figure 10 shows a simplified block diagram relating to the driving of the MEMS device of Figure 1.

Description of Embodiments

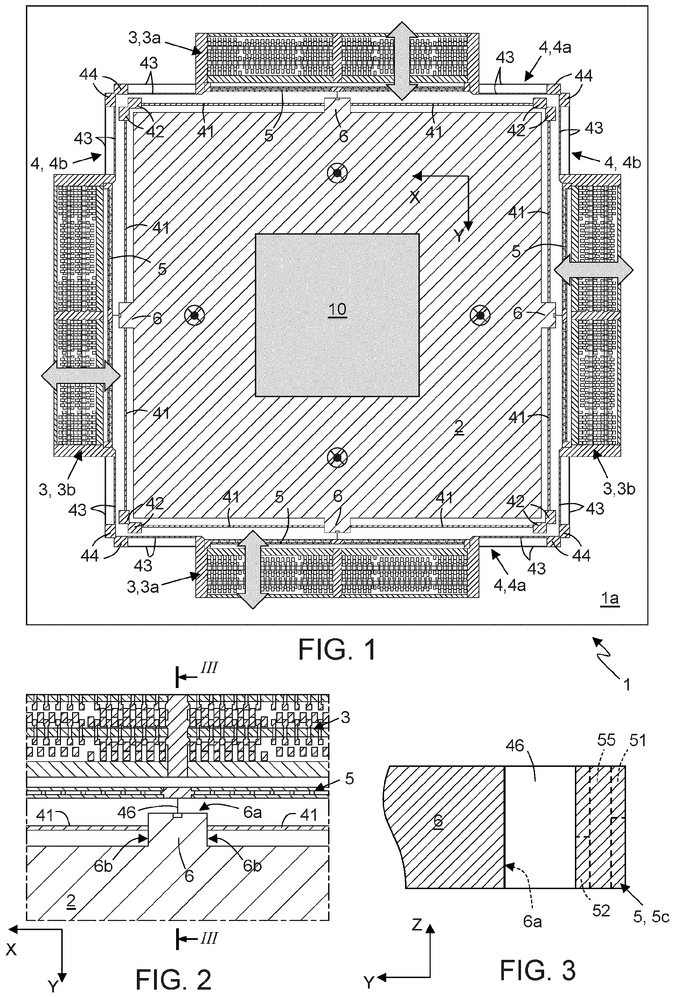

A stabilizer MEMS device (or simply "device") 1 is shown in Figure 1 according to a preferred embodiment. The device 1 comprises a substrate 1a, a platform 2 (or, support), four actuators 3 arranged around the perimeter of the platform 2 and four respective connection structures 4, one for each actuator 3. The device 1 is configured to operate as a stabilizer of an image sensor 10, for example a camera image sensor, mounted on the platform 2. The image sensor 10 therefore follows movements imparted to the platform 2, which are described below. The device 1 is formed using semiconductor materials, for example the substrate 1a and the platform 2 are made of silicon.

In detail, the platform 2 is suspended with respect to the substrate 1a and has a substantially rectangular shape in plan, and the four actuators 3 are arranged, each, adjacent to a respective side of the platform 2. Each connection structure 4 couples a respective actuator 3 with a respective side of the platform 2. The platform 2, furthermore, comprises four coupling portions 6, each protruding from a respective side of the platform 2 towards the respective actuator 3. In a non-limiting embodiment, each coupling portion 6 has a polygonal profile comprising three sides, wherein a transmission side 6a is transverse to two substantially parallel connection sides 6b, as shown in Figure 2. Each coupling portion 6 protrudes from the respective side of the platform 2 in a substantially central position.

Considering a reference system of orthogonal axes X, Y, Z, the platform 2 has a substantially planar shape parallel to the XY plane, a first pair of actuators 3a comprises actuators 3 facing opposite sides of the platform 2 parallel to the X axis and a second pair of actuators 3b comprises actuators 3 facing opposite sides of the platform 2 parallel to the Y axis. Actuators 3 of distinct pairs are therefore arranged, parallel to the XY plane, in a manner perpendicular to each other.

The platform 2 of the device 1 is operated by the actuators 3 to perform roll (rotation around the X axis), pitch (rotation around the Y axis) and out-of-plane translation (along the Z axis) movements, in order to compensate, in a closed-loop system, image blur conditions. In Figure 1 the device 1 is shown in a rest condition, i.e. when the platform 2 is not operated by any actuator 3. In a non-limiting embodiment, the platform 2 is positioned, in the rest condition, so that each side is equidistant from the respective actuator 3.

The actuators 3 of Figure 1 are linear actuators of the "in-plane" type, i.e. actuators capable of imparting movements in a plane parallel to main faces of the platform 2 along respective actuation axes; specifically, in the device 1, the first pair of actuators 3a has a first actuation axis parallel to the Y axis, while the second pair of actuators 3b has a second actuation axis parallel to the X axis. In more detail, the actuators 3 are electrostatic actuators, for example of a capacitive type, comprising fixed electrodes and movable electrodes interdigitated with each other. In Figure 1, the actuators 3 of the first pair of actuators 3a comprise a plurality of rows of electrodes offset to each other along the Y axis, each row comprising a plurality of pairs of corresponding fixed - anchored to the substrate 1a - and movable electrodes offset to each other along the X axis; the actuators 3 of the second pair of actuators 3b comprise a plurality of rows of electrodes offset to each other along the X axis, each row comprising a plurality of pairs of corresponding fixed - anchored to the substrate 1a - and movable electrodes offset to each other along the Y axis.

The movements caused by the actuators 3 are transmitted to the platform 2 by the respective connection structures 4. In detail, and with reference also to the details of Figures 2 and 3, each connection structure 4 comprises: a pair of first elastic elements 41; a pair of first anchors 42 fixed to the substrate 1a; a pair of second elastic elements 43; a pair of second anchors 44 fixed to the substrate 1a; a motion conversion elastic element 5; and a motion transmission elastic element 46.

The first elastic elements 41 and the first anchors 42 of each connection structure 4 are configured to maintain the platform 2 suspended with respect to the substrate 1a. In particular, the first anchors 42 are arranged around the vertices of the platform 2. Each first elastic element 41 of the pair connects a respective first anchor 42 to the coupling portion 6 of the corresponding side of the platform 2. More particularly, the first elastic elements 41 are connected to the corresponding coupling portion 6 on opposite sides, i.e. each to a respective connection side 6b. Each first elastic element 41 of the device 1 comprises, for example, a flexure; in addition, the first elastic elements 41 of a respective pair are arranged on opposite sides of the corresponding coupling portion 6 so as to be aligned with each other.

The second elastic elements 43 and the second anchors 44 of each connection structure 4 are configured to allow the movements of the corresponding actuator 3. In particular, the second anchors 44 are arranged on opposite sides of the actuators 3 and are also arranged alongside respective first anchors 42 in more external positions with respect to the platform 2. Each second elastic element 43 of a respective pair connects a respective second anchor 44 to the corresponding actuator 3. More particularly, the second elastic elements 43, the second anchors 44 and the actuators 3 of the device 1 surround corresponding first elastic elements 41, first anchors 42 and coupling portions 6. Furthermore, the first anchors 42 and the second anchors 44 of each connection structure 4 are arranged respectively alongside a first anchor 42 and a second anchor 44 of the adjacent connection structure 4. Each second elastic element 43 of the device 1 comprises, for example, a pair of flexures which, in the rest condition, are parallel to each other; in addition, the second elastic elements 43 of a respective pair are arranged on opposite sides of the corresponding actuator 3 and aligned with each other.

Connection structures 4 corresponding to distinct pairs of actuators 3 are arranged, parallel to the XY plane, in a manner perpendicular to each other. A first pair of connection structures 4a, corresponding to the first pair of actuators 3a, and a second pair of connection structures 4b, corresponding to the second pair of actuators 3b, may therefore be identified. In detail, the first and the second elastic elements 41, 43 of the first pair of connection structures 4a extend parallel to the X axis and the first and the second elastic elements 41, 43 of the second pair of connection structures 4b extend parallel to the Y axis. Even more in detail, the first elastic elements 41 of the device 1 are yielding with respect to the Z axis, i.e. for out-of-plane movements; the second elastic elements 43 of the device 1 are instead yielding for in-plane movements and are rigid for out-of-plane movements.

The motion conversion elastic elements 5 of each connection structure 4 are configured to convert the in-plane movements of the actuators 3 into the out-of-plane movements of the platform 2 previously described, i.e. into movements of the platform 2 along directions characterized by at least one component perpendicular to the substrate 1a. More precisely, the motion conversion elastic elements 5 are configured to convert the movements of the actuators 3 in the XY plane into corresponding movements of the respective coupling portions 6 along the Z axis. For example, the motion conversion elastic elements 5 may be formed substantially as described in the published patent application EP 3 872 451 A1, in the name of the Applicant. Hereinafter, for simplicity, reference will be made to only one of the motion conversion elastic elements 5 of the first pair of connection structures 4a and to the corresponding actuator 3; what has been stated also applies to the motion conversion elastic elements 5 of the second pair of connection structures 4b and to the respective actuators 3, taking into consideration the perpendicularity relationship in the arrangement of the actuators 3 and the connection structures 4 in the device 1 previously described.

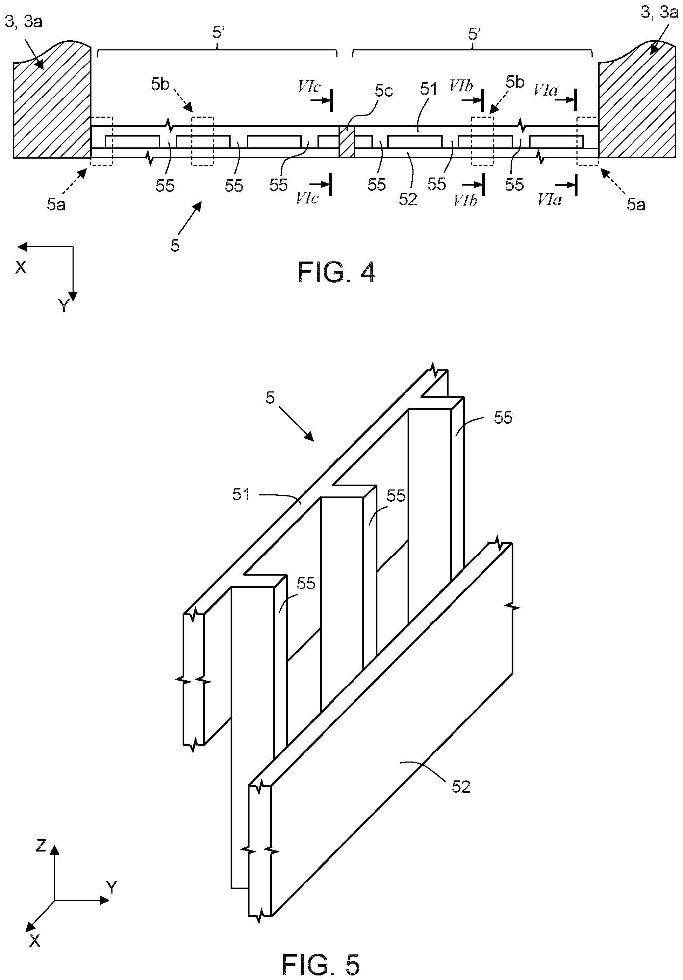

Also with reference to Figures 4 and 5, the motion conversion elastic element 5 comprises two end portions 5a and a central portion 5c; the two end portions 5a are opposite to each other along the X axis with respect to the central portion 5c; furthermore, the central portion 5c divides the motion conversion elastic element 5 into two identical sides 5', each comprising a respective end portion 5a and a respective intermediate portion 5b; each intermediate portion 5b is arranged, on the respective side 5', in a substantially median position between the central portion 5c and the respective end portion 5a. The motion conversion elastic element 5 is arranged parallel to the actuator 3, to which it is connected in positions corresponding to the two end portions 5a. The motion conversion elastic element 5 is also comprised between the actuator 3 and the respective pair of first elastic elements 41 (not shown in Figure 4), so that the central portion 5c faces the respective coupling portion 6 of the platform 2. The central portion 5c is connected to the respective coupling portion 6 (see Figures 2 and 3) by the respective motion transmission elastic element 46, which is defined by a flat plate, for example rectangular, in the rest condition perpendicular to the X axis; the motion transmission elastic element 46 is connected to the transmission side 6a of the respective coupling portion 6. In the non-limiting embodiment of Figure 1, furthermore, the motion conversion elastic element 5 is collinear with the second elastic elements 43 of the respective pair.

The motion conversion elastic element 5 comprises a first elastic body 51, a second elastic body 52 and a plurality of transverse elements 55, all of which are formed for example of the same semiconductor material as the substrate 1a and the platform 2 and form a single piece.

The first elastic body 51 and the second elastic body 52 are defined by flat rectangular plates of the same shape, in the rest condition perpendicular to the Y axis and elongated in the direction of the X axis. The first elastic body 51 and the second elastic body 52 are offset with respect to each other both in the direction of the Y axis and in the direction of the Z axis. For example, the first elastic body 51 extends adjacent to the actuator 3 and at a greater distance from the respective side of the platform 2; vice versa, the second elastic body 52 extends adjacent to the respective side of the platform 2 and at a greater distance from the actuator 3. Furthermore, the second elastic body 52 is closer to the substrate 1a than the first elastic body 51. In a non-limiting embodiment, the central portion 5c is a joint section of the motion conversion elastic element 5 which joins the first and the second elastic bodies 51, 52 and which is connected to the motion transmission elastic element 46 along the Z axis.

The transverse elements 55 are defined by flat plates of the same shape, for example rectangular, in the rest condition perpendicular to the X axis. The transverse elements 55 are uniformly spaced along the X axis and have first sides connected to the first elastic body 51 and second sides, opposite to the first sides, connected to the second elastic body 52.

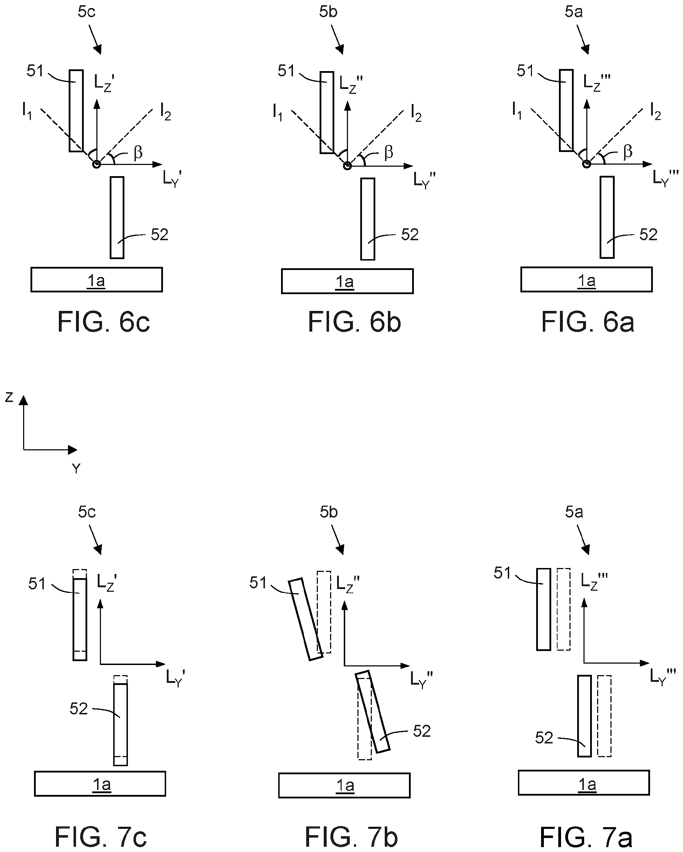

Figures 6a-6c show, by way of example, cross-sections of the motion conversion elastic element 5 along planes parallel to the YZ plane at an end portion 5a, at an intermediate portion 5b and at the central portion 5c, respectively. In each of Figures 6a-6c the main axes of inertia $I_1$, $I_2$ of the corresponding section of the motion conversion elastic element 5 are also shown, assuming that this section has infinitesimal thickness. In the rest condition, in particular, the main axes of inertia $I_1$, $I_2$ have a same orientation in each section and are misaligned and transverse with respect to both the Y axis and the Z axis. Figures 6a-6c also show, in rest conditions, pairs of local axes (indicated respectively by Ly'-Lz', Ly"-Lz" and Ly'''-Lz'''), each pair being formed by axes parallel to the Y axis and the Z axis, respectively, and passing through the barycenter of the section shown.

For each section of the motion conversion elastic element 25, a centrifugal moment of inertia $I_c$ may be calculated, with respect to the corresponding pair of local axes, through the integral:

$$I_c = \iint r_1 r_2 \, dA,$$

where $r_1$ and $r_2$ represent the distance of each point of the section from a first and a second axis of the pair of local axes respectively, while dA is the area unit of the section. The centrifugal moment of inertia $I_c$ is non-zero, since the local axes are not axes of symmetry of the section and therefore do not coincide with the main axes of inertia $I_1$, $I_2$. In particular, the main axes of inertia $I_1$, $I_2$ form an angle $\beta$ with the local axis parallel to the Z axis and with the local axis parallel to the Y axis, respectively. Consequently, as may be seen in Figures 7a-7c, a force applied on the motion conversion elastic element 5, for example along the local axis Lz", causes a skew bending of the motion conversion elastic element 5. In particular, this force causes a deformation along the local axis Lz", which entails a resulting deformation along the local axis Ly".

Compared to the rest positions, represented with a dashed line, for each side 5' of the motion conversion elastic element 5, in response to a same translation of the end portion 5a in the direction of the Y axis (Figure 7a) the skew bending causes a rototranslation of the respective intermediate portion 5b (Figure 7b) and a translation of the central portion 5c in the direction of the Z axis. Due to the skew bending, therefore, the displacement - in plane (here, along the Y axis) - caused by the actuator 3 to the two end portions 5a of the motion conversion elastic element 5 is transduced into an out-of-plane displacement of the motion transmission elastic element 46, and therefore of the platform 2 (in the condition of Figures 7a-7c , for example, corresponding to a roll movement of the platform 2).

In the device 1 the actuators 3 of each of the first and the second pairs of actuators 3a, 3b may be driven in a concordant manner or in a discordant manner. Furthermore, only the actuators 3 of one pair may be operated, while the actuators 3 of the other pair are not operated. Conversely, all the actuators 3 may be operated simultaneously: for example, the actuators 3 of each of the first and the second pairs of actuators 3a, 3b may be driven simultaneously in a discordant manner; or a mixed driving wherein the actuators 3 of a pair are driven in a concordant manner and the actuators 3 of the other pair are driven in a discordant manner is possible.

Hereinbelow the term "concordant" means that, in each of the first and the second pairs of actuators 3a, 3b, both actuators 3 cause movements in the same direction, i.e. while one actuator 3 of the pair causes movements towards the platform 2 (pushing the corresponding motion conversion elastic element 5) the other actuator 3 of the pair causes movements away from the platform 2 (pulling the corresponding motion conversion elastic element 5). The term "discordant", instead, means that, in each of the first and the second pairs of actuators 3a, 3b, the actuators 3 cause movements in opposite directions, i.e. both actuators 3 cause movements towards the platform 2 or both actuators 3 cause movements away from the platform 2.

According to what has been previously described regarding the motion conversion elastic elements 5 of each connection structure 4, in the device 1: a concordant driving of only the actuators 3 of the first pair of actuators 3a causes pure roll movements of the platform 2 (around the X axis), so that a corresponding coupling portion 6 achieves a higher height, with respect to the substrate 1a, than the opposite coupling portion 6 along the Y axis; a concordant driving of only the actuators 3 of the second pair of actuators 3b causes pure pitch movements of the platform 2 (around the Y axis), so that a corresponding coupling portion 6 achieves a higher height, with respect to the substrate 1a, than the opposite coupling portion 6 along the X axis; a discordant driving of the actuators 3 of each of the first and the second pairs 3a, 3b causes out-of-plane translation movements of the platform 2, so that all the coupling portions 6 achieve, for example, a same height with respect to the substrate 1a. Furthermore, simultaneous operations of the actuators 3, wherein the actuators 3 of each of the first and the second pairs of actuators 3a, 3b are driven in a concordant manner, cause combined roll and pitch movements of the platform 2 (for example, with a rotation axis which forms an angle of 45° with respect to the X axis and the Y axis).

The actuators 3 of the device 1 may statically maintain the platform 2 in a condition different from that of rest shown in Figure 1, according to the possible movements described, as long as the corresponding actuators 3 are suitably biased. Furthermore, all the movements of the platform 2 imparted by the actuators 3 are reversible by respective reverse operations of the actuators 3.

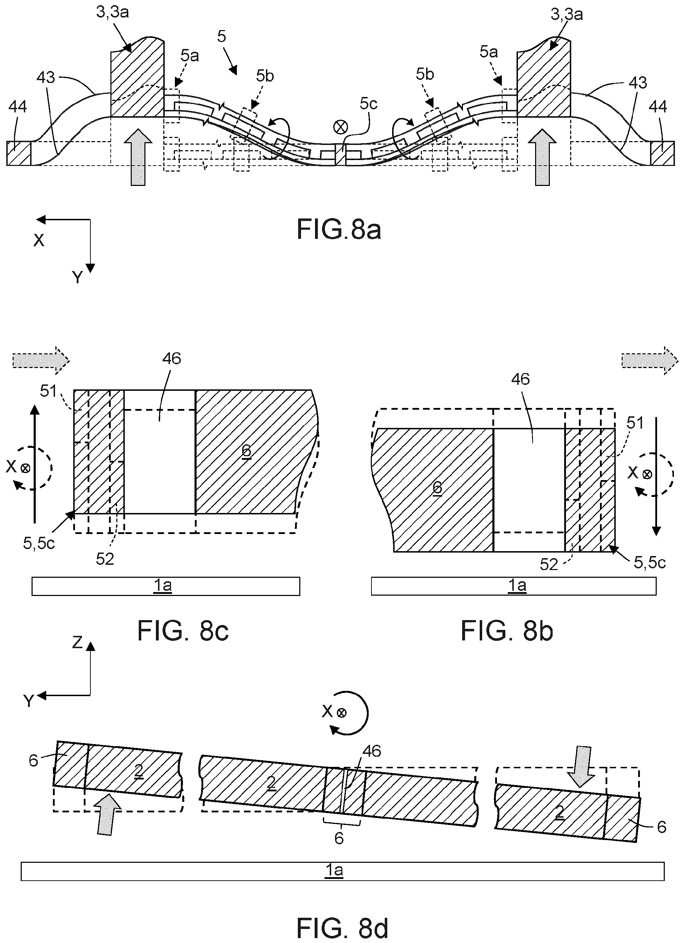

With reference to Figures 8a-8d, the actuator 3 of the first pair of actuators 3a shown in Figure 4 and the corresponding motion conversion elastic element 5 are shown, for example, when a pure roll movement is desired to be imparted to the platform 2. In detail, as shown in Figure 8a, the actuator 3 of the first pair of actuators 3a causes movements, for example, away from the platform 2, pulling the two end portions 5a of the motion conversion elastic element 5, which translate in plane along the Y axis (in negative direction); the second elastic elements 43 of the corresponding pair bend in plane following the movement of the actuator 3. Simultaneously, as previously explained, each intermediate portion 5b of the motion conversion elastic element 5 is subject to torsion and rotates around the X axis (in addition to translating along the Y axis) and the central portion 5c translates out of plane along the Z axis (downwards). Then, as shown in Figure 8b, the motion transmission elastic element 46 follows the movement of the central portion 5c of the motion conversion elastic element 5, transmitting a push along the Z axis downwards to the corresponding coupling portion 6 of the platform 2; the corresponding first elastic elements 41 (not shown in Figures 8a-8d) allow the movement of the coupling portion 6, bending downwards. The coupling portion 6 opposite (along the Y axis) to that shown in Figure 8b simultaneously receives a push along the Z axis upwards from the corresponding motion conversion elastic element 5, due to a concordant driving of the actuators 3 of the first pair of actuators 3a (Figure 8c). Figure 8d also shows the overall roll movement of the platform 2: the motion transmission elastic elements 46 of the second pair of connection structures 4b (one shown in Figure 8d) are configured to twist - without bending out of plane - thus allowing the rotation around the X axis, functioning as constraints.

Same considerations may be applied for the pure pitch movement of the platform 2, replacing the actuator 3 of the first pair of actuators 3a and the corresponding motion conversion elastic element 5 of the connection structure 4 of the first pair of connection structures 4a of Figure 8a with an actuator 3 of the second pair of actuators 3b and the corresponding motion conversion elastic element 5 of the connection structure 4 of the second pair of connection structures 4b.

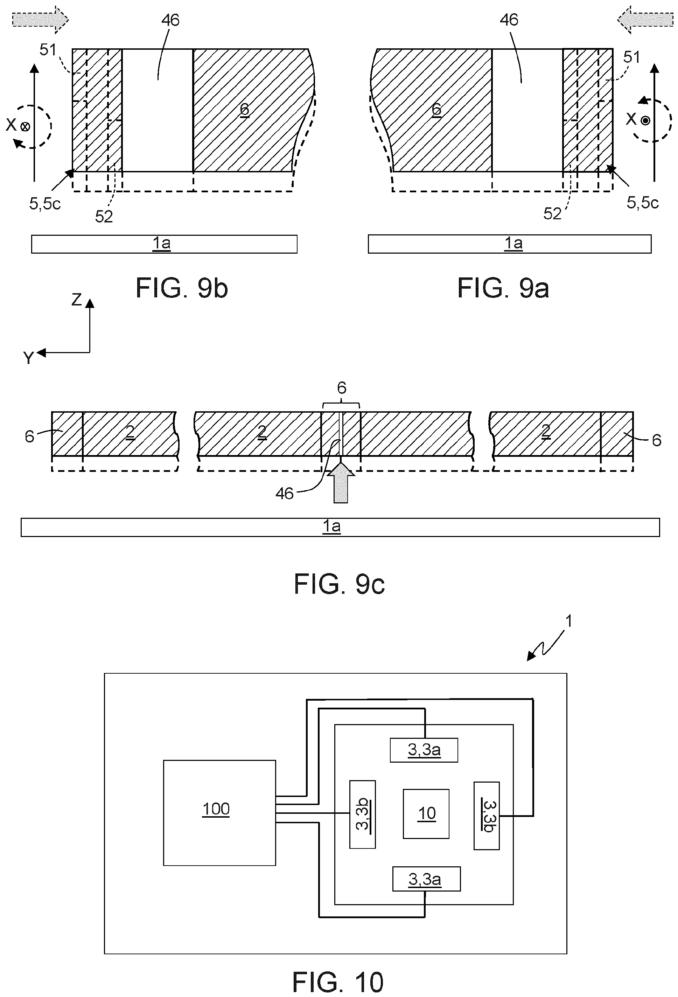

Figures 9a-9c show an out-of-plane translation, along the Z axis, of the platform 2 in the device 1. As anticipated, the actuators 3 of each of the first and the second pairs 3a, 3b are driven in a discordant manner to cause movements, for example, towards the platform 2, giving rise to a push action of the two end portions 5a of respective motion conversion elastic elements 5. Figures 9a and 9b show only portions of the motion conversion elastic elements 5 corresponding to the first pair of connection structures 4a, but same considerations apply to the motion conversion elastic elements 5 corresponding to the second pair of connection structures 4b, replacing the X axis with the Y axis. In this case, each intermediate portion 5b of a motion conversion elastic element 5 rotates around the X axis clockwise (in addition to translating along the Y axis), while each intermediate portion 5b of the opposite motion conversion elastic element 5 rotates around the X axis counterclockwise (in addition to translating along the Y axis); simultaneously, the respective central portions 5c of the motion conversion elastic elements 5 translate along the Z axis, both upwards (Figures 9a and 9b). Then, the corresponding motion transmission elastic elements 46 follow the movement of the central portions 5c, transmitting an upward push to both respective coupling portions 6 of the platform 2, which are opposite along the Y axis; each pair of first elastic elements 41 (not shown in Figures 9a-9c) allows the movement of the respective coupling portion 6, bending upwards. Figure 9c shows the overall out-of-plane translation movement of the platform 2.

With reference to Figure 10, the device 1 further comprises a control unit 100 coupled to the actuators 3. The control unit 100 is configured to provide control signals useful for driving the actuators 3 of each of the first and the second pairs of actuators 3a, 3b according to what has been previously described and therefore, ultimately, for carrying out the desired positioning correction of the image sensor 10. In particular, the signals generated by the control unit 100 and intended for the actuators 3 of each pair may be such as to cause concordant and/or discordant driving and may be of the same amplitude or of different amplitudes.

The stabilizer MEMS device of the present invention allows for an overall improvement in performance in terms of speed and accuracy of compensation for image blur conditions. Thanks to the use of motion conversion elastic elements, in fact, linear actuators may be used that cause in-plane movements in order to obtain a resulting out-of-plane actuation: such a type of actuators, for example of an electrostatic type, is characterized by capacitance values dependent on a single coordinate (here, X or Y) and therefore intrinsically has excursion ranges that are wider and have more linear dynamics with respect to types of actuators comprising structures and elements that are out of plane and/or operated directly for out-of-plane movements. Furthermore, the stabilizer MEMS device according to the invention allows to significantly reduce production costs, the energy consumption of the movement of the image sensor and the overall dimensions as only planar structures are used. A further advantage is represented by the fact that, while using in-plane actuators, out-of-plane translations (here, along the Z axis) may be generated, thus also implementing image focus functions, for example in the presence of zoom optical systems and/or for the correction of possible aberrations.

Finally, it is clear that modifications and variations may be made to what has been described and illustrated herein without thereby departing from the scope of the present invention, as defined in the attached claims.

For example, different types of in-plane actuators may be used for the stabilizer MEMS device compared to that comprising comb electrodes, obtaining the same effects and advantages described.

The platform may have different shapes from that presented and may be connected to the motion conversion elastic elements in a different manner from that described: for example, the coupling portions of the platform may have a different profile from that shown.

One or more combinations of the movements previously described may be imparted to the platform: for example, the actuators may be driven so that the platform performs both an out-of-plane translation (along the Z axis) and a roll, pitch or combination of roll and pitch movement.

**Claims**

1. A microelectromechanical device (1) comprising:

    - a substrate (1a);
    - a platform (2), suspended and movable with respect to the substrate (1a);
    - actuators (3), arranged on the substrate (1a) around the platform (2), coupled to respective coupling portions (6) of the platform (2) and having respective actuation axes (X, Y) parallel to the substrate (1a) and perpendicular to each other;
    - connection structures (4), each connection structure (4) coupling a respective actuator (3) with the platform (2) and comprising a respective motion conversion elastic element (5) interposed between the respective actuator (3) and the platform (2),

wherein each motion conversion elastic element (5) is configured to convert movements of the actuators (3) along the respective actuation axes (X, Y) into movements of the respective coupling portions (6) of the platform (2) along directions transverse to the substrate (1a).

2. The device (1) according to claim 1, wherein the platform (2) has a planar shape parallel to the substrate (1a) and comprises pairs of two-by-two parallel sides, each coupling portion (6) protruding from a respective side of the platform (2), in a substantially central position, towards the respective actuator (3).

3. The device (1) according to claim 1 or 2, wherein each motion conversion elastic element (5) comprises a central portion (5c) which divides it into two equal sides (5'), each side (5') comprising an end portion (5a) and an intermediate portion (5b),

   wherein the end portions (5a) are opposite to each other with respect to the central portion (5c) and wherein each intermediate portion (5b) is comprised between the central portion (5c) and the respective end portion (5a), and
   wherein a rototranslation of the intermediate portions (5b) parallel to a plane perpendicular to the substrate (1a) and a translation of the central portion (5c) perpendicular to the substrate (1a) correspond to a translation of the end portions (5b) parallel to the substrate (1a).

4. The device (1) according to the preceding claim, wherein the end portions (5a) of each motion conversion elastic element (5) are both connected to the respective actuator (3), and wherein the central portion (5c) is connected to the respective coupling portion (6) of the platform (2) by a respective motion transmission elastic element (46).

5. The device (1) according to the preceding claim, wherein each motion transmission elastic element (46) is configured to transmit a translation perpendicular to the substrate (1a) to the respective coupling portion (6), and wherein each motion transmission elastic element (46) is defined by a flat plate perpendicular to the substrate (1a) and is configured to twist.

6. The device (1) according to any of the preceding claims, wherein each motion conversion elastic element (5) comprises a first elastic body (51), a second elastic body (52) and a plurality of transverse elements (55),

   wherein the first and the second elastic bodies (51, 52) are defined by flat rectangular plates of the same shape, perpendicular to the substrate (1a) and offset to each other along a direction parallel to the substrate (1a) and a direction perpendicular to the substrate (1a), so that the second elastic body (52) is at a lower height, with respect to the substrate (1a), than the first elastic body (51), and
   wherein the transverse elements (55) are defined by flat rectangular plates of the same shape perpendicular to the substrate (1a), are uniformly spaced from each other and have first sides connected to the first elastic body (51) and second sides, opposite to the first sides, connected to the second elastic body (52).

7. The device (1) according to any of the preceding claims, wherein the actuators (3) are organized in a first pair of actuators (3a) having a first actuation axis (Y) parallel to the substrate (1a) and in a second pair of actuators (3b) having a second actuation axis (X) parallel to the substrate (1a) and perpendicular to the first actuation axis (Y).

8. The device (1) according to the preceding claim, comprising a control unit (100) coupled to the actuators (3) and configured to drive the actuators (3) so that the platform (2) performs at least one of the following movements or combination of movements: rotation around the first axis (X), or roll; rotation around the second axis (Y), or pitch; and translation parallel to a third axis (Z) perpendicular to the substrate (1a), or out-of-plane translation.

9. The device (1) according to the preceding claim, wherein the control unit (100) is configured to drive the actuators (3) of each of the first and the second pairs of actuators (3a, 3b) in a concordant manner or in a discordant manner.

10. The device (1) according to the preceding claim, wherein each motion conversion elastic element (5) is coupled to a respective actuator (3) and to the platform (2) so that:

   the concordant driving of the actuators (3) of the first pair of actuators (3a) causes roll movements of the platform (2) ;
   the concordant driving of the actuators (3) of the second pair of actuators (3b) causes pitch movements of the platform (2), and
   the discordant driving of the actuators (3) of each of the first and the second pairs of actuators (3a, 3b) causes out-of-plane translation movements of the platform (2).

11. The device (1) according to claim 9 or 10, wherein each motion conversion elastic element (5) is coupled to a respective actuator (3) and to the platform (2) so that the concordant driving of both the actuators (3) of the first pair of actuators (3a) and of the actuators (3) of the second pair of actuators (3b) causes combined roll and pitch movements of the platform (2).

12. The device (1) according to any of claims 7 to 11, wherein the platform (2) comprises a pair of sides parallel to the first actuation axis (Y) and a pair of sides parallel to the second actuation axis (X), and wherein the motion conversion elastic elements (5) associated with the actuators (3) of the first pair of actuators (3a) are arranged parallel to the second actuation axis (X) and wherein the motion conversion elastic elements (5) associated with the actuators (3) of the second pair of actuators (3b) are arranged parallel to the first actuation axis (Y).

13. The device (1) according to any of the preceding claims, wherein each connection structure (4) further comprises first elastic elements (41), first anchors (42) fixed to the substrate (1a), second elastic elements (43), and second anchors (44) fixed to the substrate (1a),

wherein the first elastic elements (41) and the first anchors (42) of each connection structure (4) are configured to maintain the platform (2) suspended with respect to the substrate (1a), and
wherein the second elastic elements (43) and the second anchors (44) of each connection structure (4) are configured to allow the movements of the respective actuator (3).

14. The device (1) according to the preceding claim, wherein the first anchors (42) of each connection structure (4) are arranged on opposite sides of the respective coupling portion (6) of the platform (2) and wherein each first elastic element (41) connects a respective first anchor (42) to the respective coupling portion (6), each first elastic element (41) being yielding parallel to a direction perpendicular to the substrate (1a), and
wherein the second anchors (44) of each connection structure (4) are arranged on opposite sides of the respective actuator (3) and wherein each second elastic element (43) connects a respective second anchor (44) to the respective actuator (3), each second elastic element (43) being yielding parallel to the substrate (1a).

15. The device (1) according to any of the preceding claims, wherein the actuators (3) are electrostatic linear actuators.

FIG. 1

FIG. 2

FIG. 3

FIG. 4

FIG. 5

FIG. 6c

FIG. 6b

FIG. 6a

FIG. 7c

FIG. 7b

FIG. 7a

FIG.8a

FIG. 8c

FIG. 8b

FIG. 8d

FIG. 9b

FIG. 9a

FIG. 9c

FIG. 10

# EP 4 600 202 A1

## EUROPEAN SEARCH REPORT

**Application Number**

EP 25 15 5507

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2014/069232 A1 (ELATA DAVID [IL] ET AL) 13 March 2014 (2014-03-13) * figures 3A-6D * * paragraphs [0002], [0008] - [0012], [0022], [0032] * * claim 1 * ----- | 1-15 | INV. B81B3/00 |
| A | US 2006/245027 A1 (EPITAUX MARC [US]) 2 November 2006 (2006-11-02) * figures 2, 5A-5C * ----- | 1-15 | |

**TECHNICAL FIELDS SEARCHED (IPC)**

B81B

The present search report has been drawn up for all claims

| Place of search | Date of completion of the search | Examiner |
|---|---|---|
| Berlin | 26 May 2025 | McGinley, Colm |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.......................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 15 5507

This annex lists the patent family members relating to the patent documents cited in  the above-mentioned European search report.
The members are as contained in the European Patent Office EDP file on
The European Patent Office is in no way liable for these particulars which are merely given for the purpose of information.

26-05-2025

| Patent document cited in search report | Publication date | Patent family member(s) | | Publication date |
|---|---|---|---|---|
| US 2014069232 A1 | 13-03-2014 | NONE | | |
| US 2006245027 A1 | 02-11-2006 | TW | I311980 B | 11-07-2009 |
| | | US | 2006245027 A1 | 02-11-2006 |
| | | WO | 2006110304 A1 | 19-10-2006 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3872451 A1